# EUROPEAN PATENT APPLICATION

(11) **EP 3 547 810 A1**
(43) Date of publication of application: **02.10.2019**
(21) Application number: 19164839.3
(22) Date of filing: 25.03.2019
(51) Int. Cl.: H05K 5/00

(54) **ELECTRONIC COMPONENT MODULE, ELECTRIC CONNECTION BOX, AND WIRE HARNESS**

(30) Priority: 26.03.2018 JP 2018057550
(71) Applicant: YAZAKI CORPORATION, Minato-ku, Tokyo 108-8333 (JP)
(72) Inventor: KAWAMURA, Yukihiro, Makinohara-shi, Shizuoka 421-0407 (JP)
(74) Representative: Grünecker Patent- und Rechtsanwälte PartG mbB

(57) **Abstract**

An electronic component module includes a housing and a substrate which is configured to be housed in the housing. The substrate has a substrate side part which extends straight in a housing direction to the housing and which is configured to be guided to the housing when the substrate is housed. The housing has a substrate guide part which is configured to guide the substrate side part when the substrate is housed, a housing side wall on which the substrate guide part is formed, and a locked part which is formed to be continuous to an outer surface of the housing side wall and which is locked to an attachment destination.

## Description

### BACKGROUND OF THE INVENTION

### <Field of the Invention>

The present invention relates to an electronic component module which includes a housing and a substrate which is housed inside the housing from the outside, to an electric connection box which includes the electronic component module and a frame which houses and locks the electronic component module therein, and to a wire harness which includes the electric connection box and is arranged in an automobile.

### <Description of Related Art>

The technology of an electronic component module and an electric connection box is disclosed in (see, for example, the patent document 1: JP-A-2017-103914). The electronic component module includes a housing, a substrate which is housed inside the housing from the outside, and a connector block which is assembled to the substrate and is fitted to an opening part of the housing. In addition, the electric connection box includes the electronic component module and a frame which houses and locks the electronic component module. Further, the electric connection box is mounted on a vehicle, and the electronic component module is exemplified by a relay module or the like.

The frame configuring the electric connection box has a locking part for housing and locking the electronic component module therein. Further, in the electronic component module which is locked by the locking part, a locked part is formed on the side wall outer surface of the housing to project from the outer surface. When the locked part of the housing is locked by the locking part of the frame, the electronic component module is housed and held in the electric connection box.

[Patent Document 1] JP-A-2017-103914

An apparatus mounted on the vehicle such as the above-described electric connection box of the conventional technology needs to meet the requirement of miniaturization.

### SUMMARY

One or more embodiments provide an electronic component module, an electric connection box which are reduced in size, and a wire harness which includes the electric connection box.

In an aspect (1), an electronic component module includes a housing and a substrate which is configured to be housed in the housing. The substrate has a substrate side part which extends straight in a housing direction to the housing and which is configured to be guided to the housing when the substrate is housed. The housing has a substrate guide part which is configured to guide the substrate side part when the substrate is housed, a housing side wall on which the substrate guide part is formed, and a locked part which is formed to be continuous to an outer surface of the housing side wall and which is locked to an attachment destination.

According to the aspect (1), the housing side wall is arranged at a position inside the outer surface (hereinafter, a guide part outer surface) of the portion where the substrate guide part is formed. Thus, the housing side wall can be arranged such that the housing is reduced in size compared to the conventional one. In addition, the locked part with respect to the attachment destination of the electronic component module is arranged in a range from the outer surface of the housing side wall arranged inside the substrate as described above to the position of the guide part outer surface. Thus, the locked part can be arranged further toward the inner side of the substrate compared to the conventional one (that is, be arranged to be reduced in size). Accordingly, the electronic component module can be reduced in size by the amount of being arranged toward the inner side of the substrate as described above. The substrate guide part has a shape in which an end portion of the substrate side part is configured to be positioned outside the outer surface of the housing side wall when the substrate is housed. The locked part is positioned in a range from the outer surface of the housing side wall to an outer surface of the substrate guide part.

In an aspect (2), the housing has a guided part which is continuous to the outer surface of the housing side wall and which is configured to be guided by a guide part of the attachment destination. A base part of the guided part and the substrate guide part are integrally formed.

According to the aspect (2), the base part of the guided part is also used for the substrate guide part. Thus, the structure of the housing can be simplified as well as effective for miniaturization.

In an aspect (3), the electronic component module further comprises a block-shaped member which is assembled to the substrate and which is fitted to an opening part of the housing. The block-shaped member has a flange part which is positioned to be flush with the substrate side part and which is configured to be guided together with the substrate side part by the substrate guide part.

According to the aspect (3), the substrate side part and the flange part are guided together by the substrate guide part. Thus, the block-shaped member fitted to the opening part of the housing can be also prevented from rattling as well as the substrate.

In an aspect (4), an electric connection box includes the electronic component module according to any one of the aspects (1) to (3) and a frame which houses and locks the electronic component module in the frame.

According to the aspect (4), the configuration includes the electronic component module reduced in size. Thus, the frame which houses and locks the electronic component module can be reduced in sized, and as a result, the electric connection box itself can be also reduced in size.

In an aspect (5), a wire harness includes the electric connection box according to the aspect (4) in a terminal thereof. The wire harness is configured to be arranged in a vehicle.

According to the aspect (5), the wire harness can be provided which is more excellent.

According to one or more embodiments, an electronic component module and an electric connection box can be provided which are reduced in size. Further, the wire harness can be provided which is more excellent.

### BRIEF DESCRIPTION OF THE DRAWINGS

Fig. 1 is a perspective view illustrating one embodiment of an electronic component module and an electric connection box.
Fig. 2 is a front view of the electronic component module.
Fig. 3 is a side view of the electronic component module.
Fig. 4 is a back view of the electronic component module.
Fig. 5 is an exploded perspective view of the electronic component module.
Fig. 6 is an exploded perspective view of the electronic component module.
Fig. 7 is a plan view of a substrate and a connector block.
Fig. 8 is a sectional view taken along line A-A of Fig. 3 (a portion in a circle is an expanded view).
Fig. 9 is a sectional view taken along line B-B of Fig. 3 (a portion in a circle is an expanded view).
Fig. 10 is an expanded view of Fig. 9.
Fig. 11 is a cross-sectional perspective view of a housing taken along line C-C of Fig. 4.
Fig. 12 is a sectional view of the housing taken along line D-D of Fig. 4.
Fig. 13 is a sectional view taken along line D-D of Fig. 4 (just before the connector block is fitted).
Fig. 14 is a sectional view taken along line D-D of Fig. 4.
Fig. 15 is a perspective view from a back surface side of the electronic component module (including a sectional view taken along line E-E of Fig. 3).

### DETAILED DESCRIPTION

An electronic component module includes a substrate, a connector block, and a housing. The substrate is a member which is housed inside the housing and has a substrate side part which extends straight in a housing direction to the housing and is guided to the housing at the time of housing. The housing has a substrate guide part, a housing side wall in which the substrate guide part is formed, and a locked part which is continuous to the outer surface of the housing side wall. The substrate guide part is formed in such a shape that the end portion of the substrate side part is positioned on the outer side from the outer surface of the housing side wall. The locked part is arranged in a range from the outer surface of the housing side wall to the position of an outer surface of a portion where the substrate guide part is formed. The electric connection box includes the electronic component module and a frame. The electric connection box is mounted on a vehicle. The electric connection box is provided in a terminal of a wire harness which is arranged to the vehicle.

### [Embodiment]

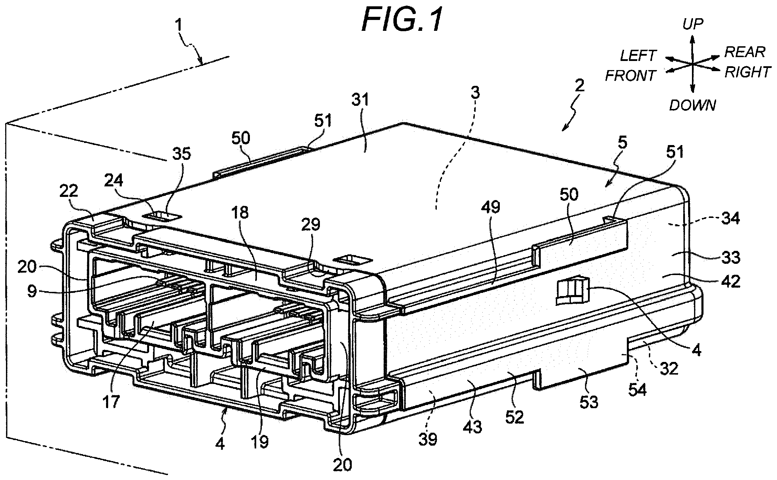

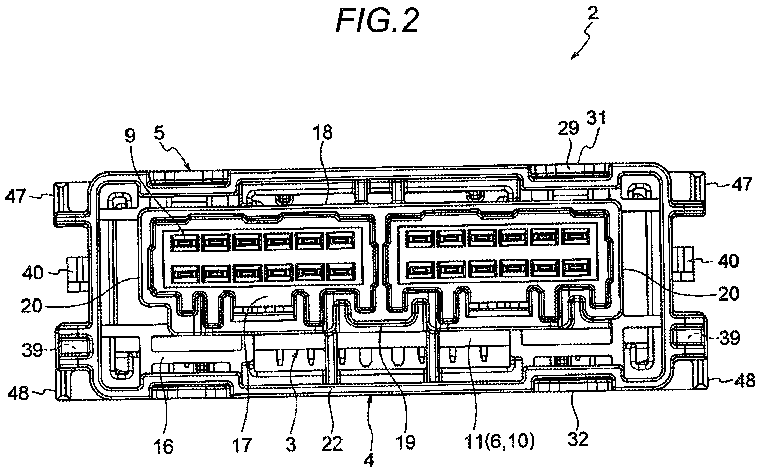

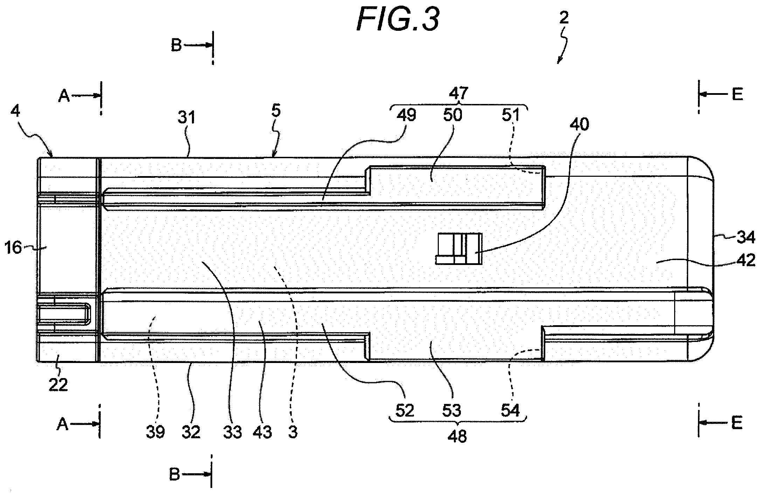

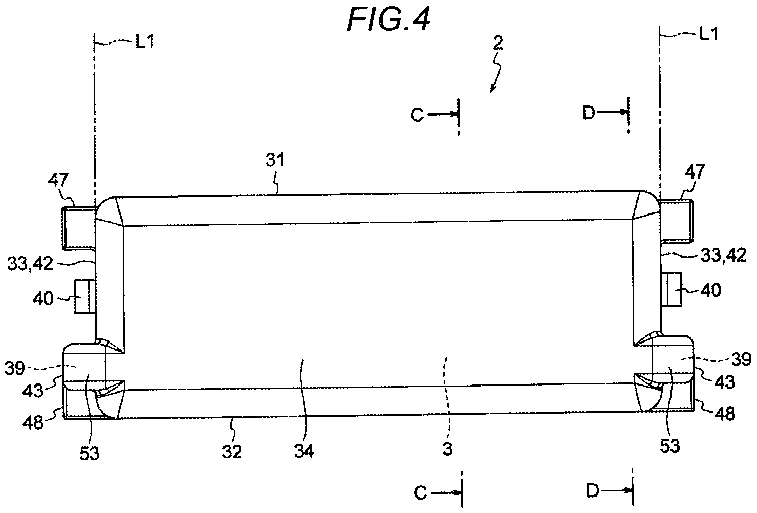

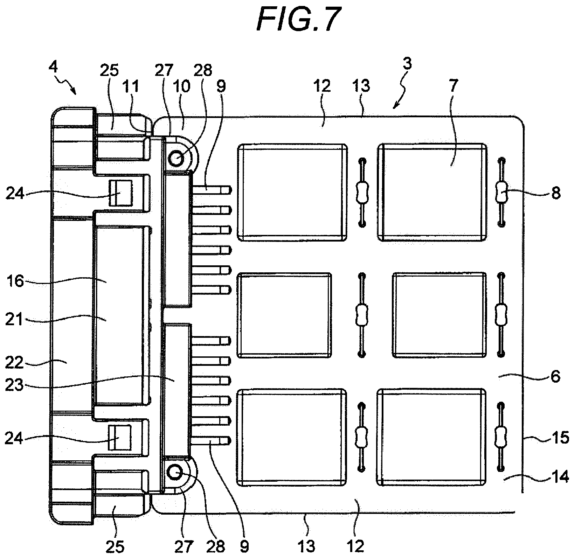

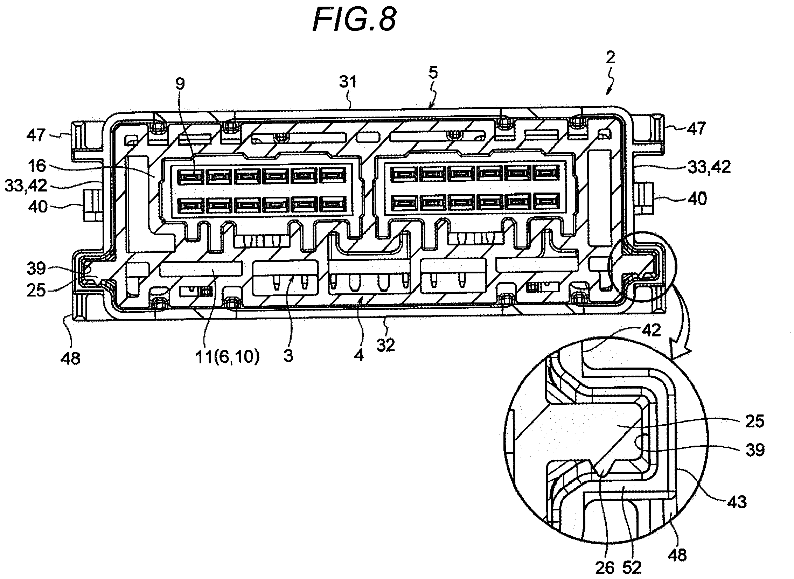

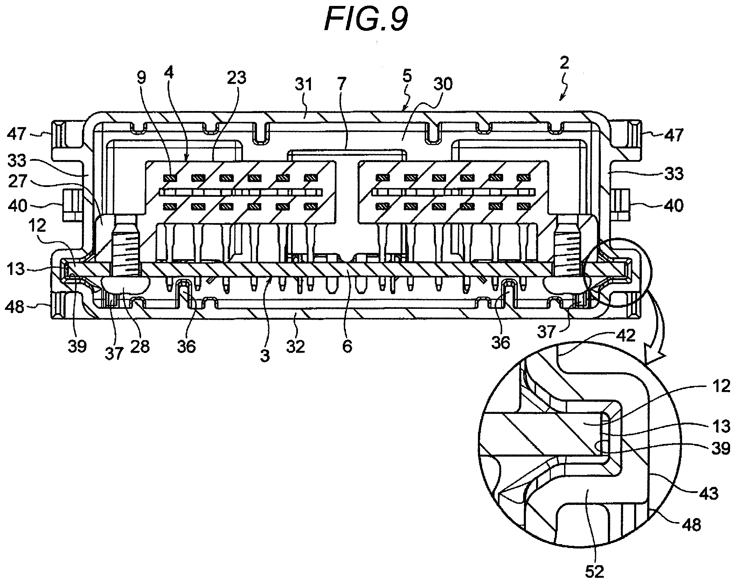

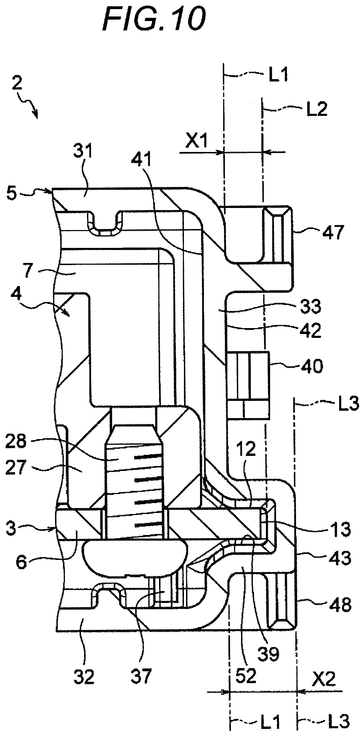

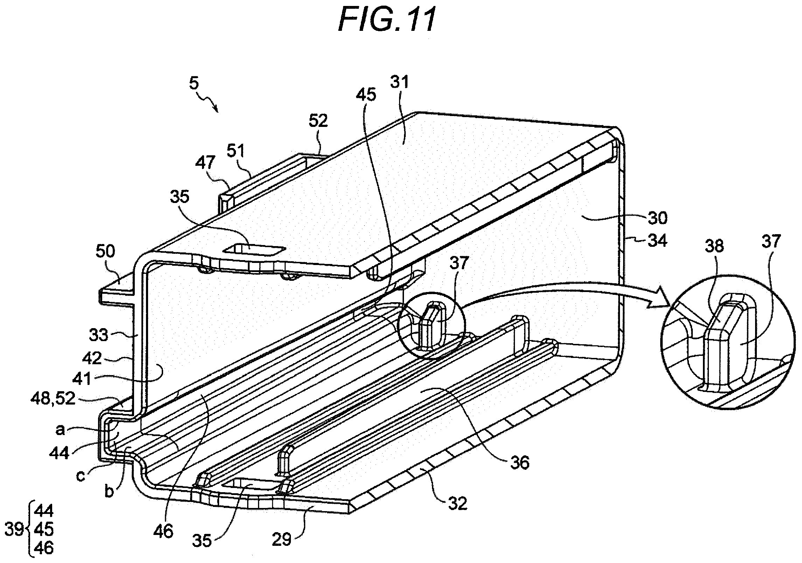

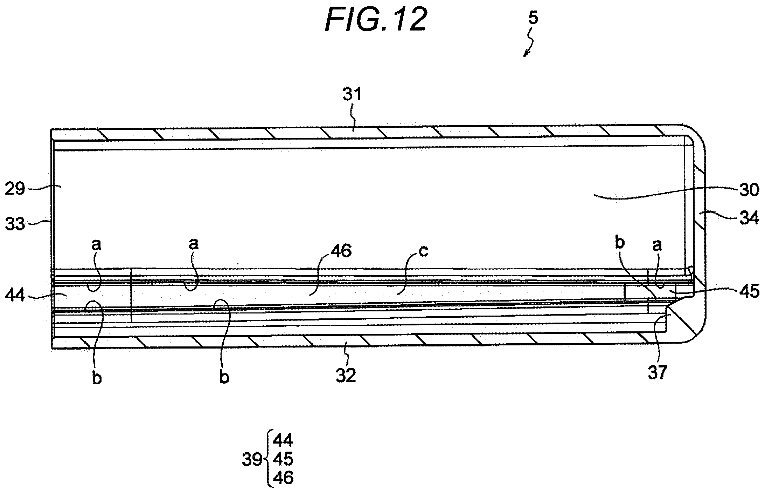

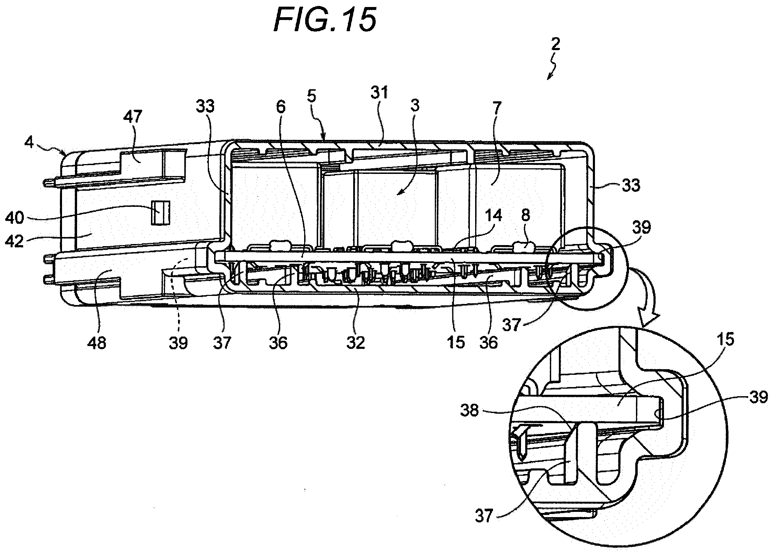

Hereinafter, a first embodiment will be described with reference to the drawings. Fig. 1 is a perspective view illustrating one embodiment of the electronic component module and the electric connection box of the invention. In addition, Figs. 2 to 6 are a front view, a side view, a back view, and an exploded perspective view of the electronic component module. In addition, Fig. 7 is a plan view of the substrate and the connector block, Fig. 8 is a sectional view taken along line A-A of Fig. 3, Fig. 9 is a sectional view taken along line B-B of Fig. 3, and Fig. 10 is an expanded view of Fig. 9. In addition, Fig. 11 is a cross-sectional perspective view of the housing taken along line C-C of Fig. 4, Fig. 12 is a sectional view of the housing taken along line D-D of Fig. 2, Figs. 13 and 14 are a sectional view taken along line D-D of Fig. 4, and Fig. 15 is a cross-sectional perspective view taken along line E-E of Fig. 3. Further, the arrows of Fig. 1 indicate fron-and-rear, left-and-right, and vertical directions respectively (the directions are one example).

### <Electric Connection Box 1>

In Fig. 1, for example, an electric connection box 1 mounted on the vehicle is provided in a part of the wire harness (not illustrated) which is arranged at a predetermined position of the vehicle to electrically connect the apparatuses. The electric connection box 1 includes an electronic component module 2, a frame (which is not illustrated and configures the main body of the electric connection box) which can house and lock the electronic component module 2 therein, and an upper cover and a lower cover which cover an upper opening and a lower opening of the frame. Further, the electric connection box 1 serves as the attachment destination of the electronic component module 2.

### <Configuration of Electronic Component Module 2>

In Figs. 1 to 6, the electronic component module 2 is called, for example, a relay module or an apparatus control module. Herein, the former is described as one example. The electronic component module 2 as the relay module includes a substrate 3, a connector block 4 (a block-shaped member), and a housing 5. In this embodiment, the electronic component module 2 may be configured such that a smaller electric connection box is in the electric connection box 1. As will be understood from the following description, in the electronic component module 2, the size is reduced as compared to the conventional one, and rattling is suppressed.

### <Substrate 3>

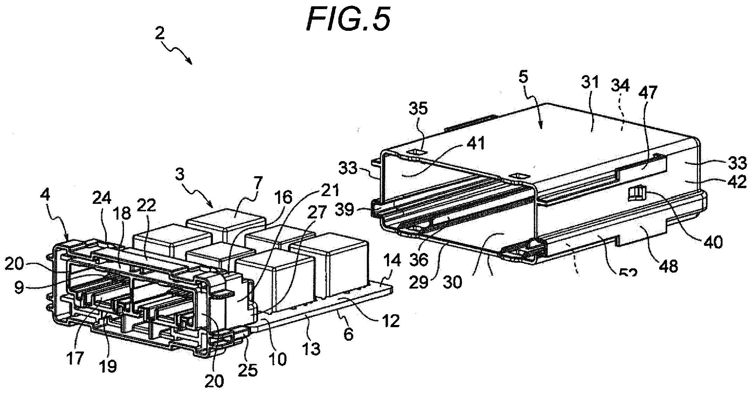

In Figs. 5 to 7, the substrate 3 has a substrate body 6 which is a plate-shaped member rectangular in plan view. In the substrate body 6, a desired circuit (not illustrated) is formed on the rear surface which is a surface on the lower side thereof. In addition, a plurality of small through holes (not illustrated) are formed in the substrate body 6. A plurality of relays 7 and resistances 8 are mounted at the surface side of the substrate body 6 by using the through hole. The relay 7 and the resistance 8 are connected to the circuit by soldering at the rear surface side. In addition, a plurality of pin terminals 9 are also provided on the surface side of the substrate body 6. The pin terminal 9 is inserted into the through hole and is connected to the circuit by soldering. The pin terminal 9 is formed in such an L shape that the base end side is arranged in a substrate front portion 10 of the substrate body 6, and the tip side projects outward from the end portion 11 of the substrate front portion 10. The tip side of the pin terminal 9 is arranged to penetrate the connector block 4 and to perform the connector connection in the connector block 4.

Right and left reference signs 12 in the substrate body 6 indicate substrate side parts. In addition, a reference sign 13 in the substrate side part 12 indicates the end portion of the substrate side part 12. In addition, a reference sign 14 indicates the substrate rear portion, and a reference sign 15 indicates the end portion of the substrate rear portion 14.

The relay 7 and the resistance 8 are mounted at the positions (the inside of the substrate body 6) which are inside the end portion 13 of the substrate side part 12 and the end portion 15 of the substrate rear portion 14. More specifically, the relay 7 and the resistance 8 are mounted at the positions which are further inner side of the substrate body 6 than the substrate side part 12.

The substrate side part 12 is formed at the portion where the end portion 13 extends straight along a longitudinal direction (along a housing direction to the housing 5). In addition, the substrate side part 12 is formed at the portion where the front and rear surfaces (the front and rear surfaces of the substrate body 6) of the portion are parallel to each other. The substrate side part 12 is formed as a portion (a portion to be guided), which is guided to a substrate guide part 39 (to be described later), of the housing 5. The substrate rear portion 14 is formed at the portion where the end portion 15 extends straight along the lateral direction. In addition, the end portion 15 of the substrate rear portion 14 is formed at the portion parallel to the end portion 11 of the substrate front portion 10.

Further, the substrate 3 is not limited the above-described configuration but, for example, may be a substrate (bus bar insertion wiring board) or the like using a bus bar.

### <Connector Block 4>

In Figs. 1, 2, 5, 6, and 7, the connector block 4 is configured to be assembled to the substrate front portion 10 of the substrate 3 and to enable the connector connection in the electric connection box 1. Such a connector block 4 has a block body 16 which is a resin molded article. The connector block 4 is configured to function as a connector by allowing the tip side of the pin terminal 9 of the substrate 3 to penetrate the block body 16. As understood from the above description, the connector block 4 includes the block body 16 and (the tip side of) the pin terminal 9.

The block body 16 has a connector connection part 17 which is formed by opening the front portion. The connector connection part 17 is a portion for performing the connector connection, and the tip side of the pin terminal 9 projects therein. The periphery of the connector connection part 17, that is, a block upper part 18, a block lower part 19, and right and left block side parts 20 are formed in an illustrated shape to have a fitting part 21 which is fitted to an opening part 29 (to be described later) of the housing 5 and a frame part 22. The block rear portion 23 is formed at such a portion that the tip side of the pin terminal 9 can penetrate to the connector connection part 17.

In each of the block upper part 18 and the block lower part 19, a pair of locking convex parts 24 are formed as portions (the portion to be locked) which are fitted to the opening part 29 (to be described later) of the housing 5. In addition, flange parts 25 which are guided in the substrate guide part 39 (to be described later) of the housing 5 are formed in right and left block side parts 20, respectively. The flange part 25 is formed substantially flush with the front and rear surfaces of the substrate side part 12 of the substrate 3 and is formed as a portion which is guided together with the substrate side part 12 to the substrate guide part 39. The flange part 25 is formed to be a piece-shaped portion which extends small and straight along the longitudinal direction (along the housing direction of the substrate 3 to the housing 5). It is a matter of course that such a flange part 25 is effective as a portion of suppressing rattling of the block body 16 fitted to the opening part 29 of the housing 5 and rattling of the substrate 3. In addition, it is a matter of course that the flange part 25 is more effective when a fine rib 26 indicated by a circle of Fig. 8 is formed in the lower portion thereof. The fine rib 26 is formed to be a projecting portion for press-fitting with respect to the substrate guide part 39. That is, the fine rib 26 is formed to be a projecting portion which is crushed when being guided to the substrate guide part 39 (the rattling of the flange part 25 can be suppressed reliably by a press-fit structure, and further, the fine rib 26 in the drawing is illustrated in a non-crushed state for convenience).

In Figs. 7, 9, and 10, a reference sign 27 in the block rear portion 23 indicates a substrate fixing part. The substrate fixing part 27 is fixed to the substrate body 6 with a screw 28. The substrate fixing part 27 is formed to be arranged in the vicinity of the flange part 25 (the flange part 25 is arranged close to the fixing portion, and thus, advantageously, the positional deviation between the flange part 25 and the substrate side part 12 is hardly caused).

<Housing 5>

In Figs. 1 to 6, the housing 5 is a resin molded article and is formed to be a bottomed box shape having the opening part 29 and an internal housing space 30. Specifically, the housing 5 is formed in the illustrated bottomed box shape to have the opening part 29 which is open in an approximately rectangular shape, a housing upper wall 31 and a housing lower wall 32 which are arranged up and down to form the opening part 29, the housing side wall 33 which is arranged left and right to form the opening part 29, and a housing bottom wall 34 which is arranged on the deepest side from the opening part 29. As will be understood from the following description, in the housing 5, a gap between right and left housing side walls 33 is narrower than the conventional one, and as a result, the housing 5 has a structure in which the electronic component module 2 itself is reduced in size compared to the conventional one.

In Figs. 5, 6, and 11, the housing upper wall 31 and the housing lower wall 32 are rectangular walls which are opposed to each other with a gap of the opening part 29 and the internal housing space 30 interposed therebetween, and a pair of locking recess parts 35 are formed on the side of the opening part 29. In this embodiment, the locking recess part 35 is formed in a rectangular through-hole shape. The locking recess part 35 is formed as a portion (the portion which locks the locking convex part 24 to prevent falling-off) for fitting the connector block 4 inserted through the opening part 29. The outer surfaces of the housing upper wall 31 and the housing lower wall 32 are formed flat. On the other hand, a plurality of ribs (a reference sign is omitted) which extend straight in the longitudinal direction are formed on the inner surface side. The plurality of ribs of which the reference signs are omitted are formed as portions which are used to fit the connector block 4. A pair of ribs (reference sign 36) projecting from the inner surface of the housing lower wall 32 are formed to support the substrate 3 housed in the housing 5. The rib 36 is formed to project to the position in contact with the lower surface of the substrate body 6. The rib 36 is formed to extend straight from the opening part 29 to the housing bottom wall 34 (see Fig. 11).

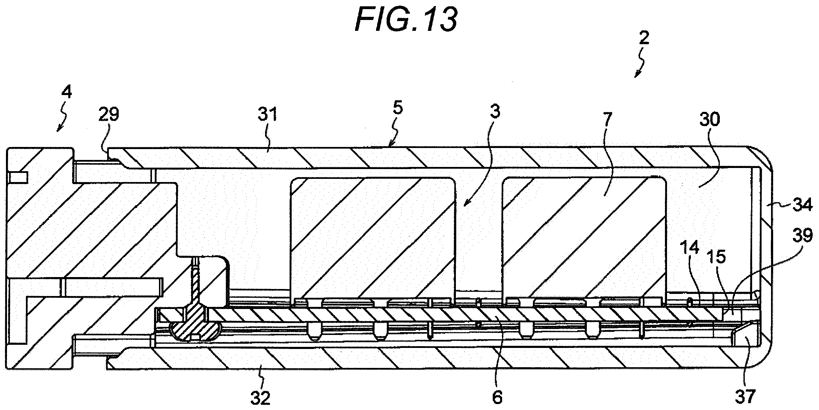

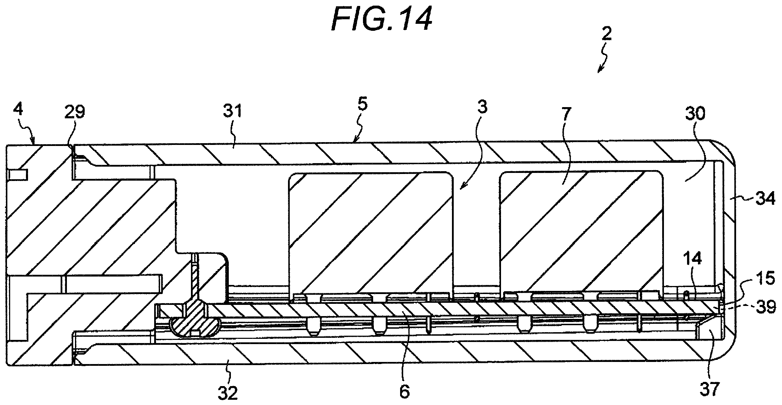

In Figs. 11 and 12, a pair of ribs (looseness suppression rib 37) are formed on the inner surface side of the housing lower wall 32. The looseness suppression rib 37 is formed to be arranged outside the rib 36. In addition, the looseness suppression ribs 37 are formed to be arranged in the vicinity of the right and left housing side walls 33. Further, the looseness suppression rib 37 is formed to be arranged continuous to the housing bottom wall 34. The looseness suppression rib 37 is formed as a rib which projects at the deepest portion of the internal housing space 30 and is short in the longitudinal direction. Such a looseness suppression rib 37 has a taper 38, and the portion of the taper 38 is formed to project slightly higher than the rib 36. The taper 38 is formed as a portion (see Figs. 13 and 14) where the end portion 15 of the substrate body 6 is brought into slide contact. In addition, the taper 38 is formed as a portion which lifts the substrate rear portion 14 slightly upward (to be warped) and presses the surface of the substrate rear portion 14 against the substrate guide part 39 (to be described later). In other words, the taper 38 is formed as a portion which can reliably suppress the rattling at the position of the substrate rear portion 14 by such pressing. Further, the taper 38 of this embodiment is formed as an inclined portion which can absorb the fitting looseness between the locking recess part 35 on the opening part 29 side and the locking convex part 24.

### <Housing Side Wall 33>

In Figs. 1 to 6, each of the right and left housing side walls 33 is an elongate wall which is continuous to the housing upper wall 31 and the housing lower wall 32 and extends from the opening part 29 to the housing bottom wall 34, and has the substrate guide part 39 and the locked part 40. Further, in the housing side wall 33, a reference sign 41 indicates an inner surface, and a reference sign 42 indicates an outer surface. The housing side wall 33 is arranged such that the outer surface 42 is positioned along a two-dot chain line L1 of Figs. 4 and 10.

### <Substrate Guide Part 39>

In Figs. 8 to 12, the substrate guide part 39 is formed as a groove-shaped portion which can guide the substrate side part 12 of the substrate body 6 and the flange part 25 of the block body 16 when the substrate 3 is housed in the internal housing space 30 (see Fig. 5) of the housing 5. The groove-shaped substrate guide part 39 is formed in such a shape that the inner surface 41 of the housing side wall 33 is recessed, and the outer surface 42 side is projected. In addition, the substrate guide part 39 is formed in such a shape that the end portion 13 of the substrate side part 12 guided by the substrate guide part 39 is positioned at a two-dot chain line L2 outside the outer surface 42 of the housing side wall 33. Further, a reference sign 43 in Fig. 10 indicates the outer surface (guide part outer surface) of the portion where the substrate guide part 39 is formed. The guide part outer surface 43 is a surface positionally corresponding to "the side wall outer surface of the housing" in a conventional example.

Herein, when the position of the guide part outer surface 43 is indicated by a two-dot chain line L3, it is understood that (the outer surface 42 of) the housing side wall 33 is moved inward to the position of the two-dot chain line L1 of this case (to the inside of the substrate body 6) from the position of the conventional example (from the position of the two-dot chain line L3). Accordingly, it is understood that the housing 5 can be reduced in size by the amount of the lateral movement by adopting the state of forming the housing side wall 33 and the substrate guide part 39.

As for the state of forming the housing side wall 33 and the substrate guide part 39, to put it in another way, it can be said that the housing side wall 33 is arranged in the vicinity of the relay 7 with leaving the portion of the substrate guide part 39 (see Fig. 10).

In Fig. 12, the substrate guide part 39 is formed such that the gap in a vertical direction is varied depending on the position in the longitudinal direction. Specifically, the portion (front guide part 44) continuous to the opening part 29 is formed with the widest gap, and the portion (rear guide part 45) continuous to the housing bottom wall 34 is inversely formed with the narrowest gap. In addition, in the substrate guide part 39, the intermediate portion (intermediate guide part 46) is formed such that the gap is narrowed gradually. The front guide part 44 is formed such that an upper groove side surface a and a lower groove side surface b become parallel. In addition, similarly, the rear guide part 45 is formed such that the upper groove side surface a and the lower groove side surface b become parallel. The intermediate guide part 46 is formed such that the upper groove side surface a is flush with the front guide part 44 and the rear guide part 45, and the lower groove side surface b is inclined from the front guide part 44 toward the rear guide part 45. The front guide part 44 is formed as a portion which guides the substrate side part 12 of the substrate body 6, and guides and holds the flange part 25 of the block body 16 finally (see Fig. 8). The rear guide part 45 is formed as a portion which guides and holds a boundary portion between the substrate side part 12 and the substrate rear portion 14 (see Figs. 14 and 15). Further, the boundary portion is held without rattling by the operation of the looseness suppression rib 37 (see Figs. 14 and 15).

In Fig. 12, when the substrate guide part 39 is described supplementally, the substrate guide part 39 is formed to be a flat surface in which the portion (the projection part of the reference sign 49 in the conventional example (JP 2017-103914 A)) projecting from the groove bottom surface c toward a groove opening is not present. In other words, the substrate guide part 39 is formed to be a portion which has an excellent shape stability such that the portion which is undercut when the housing 5 is resin-molded is not present.

### <Locked Part 40>

In Fig. 1, the locked part 40 is used as a portion which is locked to a frame (not illustrated) which is an attachment destination in the electric connection box 1. As illustrated in Figs. 1 to 4 and 10, the locked part 40 is formed to be a claw-shaped projection portion which is arranged at the intermediate position of the housing side wall 33 in the longitudinal direction and projects small outward from the outer surface 42 of the housing side wall 33 (the shape is one example). In Fig. 10, the locked part 40 is arranged in a range from the outer surface 42 of the housing side wall 33 to the position where the end portion 13 of the substrate side part 12 is present (is arranged in a range X1 from the two-dot chain line L1 to the two-dot chain line L2). The locked part 40 is formed to be arranged in a range X2 of the position inside the two-dot chain line L3 (is formed to be arranged at the position inside the guide part outer surface 43 corresponding to "the side wall outer surface of the housing" of the conventional example. From the position of the locked part 40, it is understood that the electronic component module 2 is reduced in size).

In Figs. 1 to 4 and 10, the outer surface 42 of the housing side wall 33 is formed with guided parts 47 and 48 in addition to the locked part 40. The guided parts 47 and 48 are formed as rail-shaped portions which are guided to the guide part of the frame (not illustrated). The guided part 47 is formed in an illustrated shape to have a rail-shape base part 49 which extends straight in the longitudinal direction, a tip part 50 which projects upward from the tip of the base part 49, and a stopper part 51. In addition, similarly, the guided part 48 is also formed in an illustrated shape to have a base part 52, a tip part 53, and a stopper part 54. The base part 52 of the guided part 48 is formed as a portion which is also used for the substrate guide part 39 (the dual-purpose use is effective to reduce the electronic component module 2 in size, and the structure of the housing 5 can be simplified). As illustrated in Fig. 10, the guided parts 47 and 48 are formed in the range X2 to the two-dot chain line L3.

### <Assembly of Electronic Component Module 2>

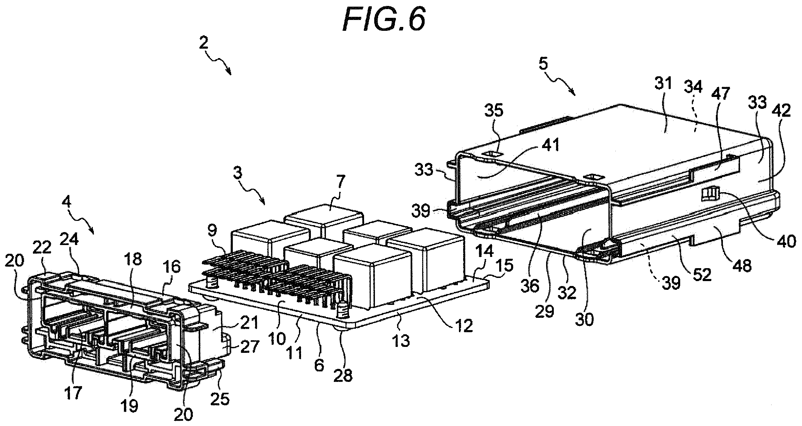

When the connector block 4 is assembled with the substrate 3 in the state illustrated in Fig. 6, the connector block 4 and the substrate 3 are integrated into the substrate 3 in which the connector block 4 is assembled as illustrated in Figs. 5 and 7. When the substrate 3 in which the connector block 4 is assembled is housed in the internal housing space 30 of the housing 5 through the opening part 29 (see Fig. 5), the substrate side part 12 of the substrate body 6 and the flange part 25 of the block body 16 are guided by the substrate guide part 39 at the time of housing (see Figs. 9 and 13 with respect to the guided state). When the connector block 4 is fitted at the portion of the opening part 29 (see Fig. 8), and the end portion 15 of the substrate rear portion 14 in the substrate body 6 faces or abuts on the inner surface of the housing bottom wall 34 (see Fig. 14), the assembly of the electronic component module 2 is completed to be in an assembly state illustrated in Fig. 1. In a state where the assembly of the electronic component module 2 is completed, the substrate 3 is reliably held without rattling at the longitudinal position of the electronic component module 2 (see Figs. 8, 14, and 15). Thereafter, the electronic component module 2 is assembled to the frame (not illustrated) to configure the electric connection box 1 (see Fig. 1).

### <Effect>

Hereinbefore, as described with reference to the Figs. 1 to 15, according to the electronic component module 2 which is one embodiment of the invention, the housing side wall 33 is arranged at a position inside the position of the end portion 13 of the substrate side part 12. Thus, the housing side wall 33 can be arranged such that the housing 5 is reduced in size compared to the conventional one. In addition, the locked part 40 with respect to the frame (not illustrated) which is the attachment destination of the electronic component module 2 is arranged in the range X1 from the outer surface 42 of the housing side wall 33 arranged inside the substrate as described above to the position of the end portion 13 of the substrate side part 12 (in the range X2 to the position of the outer surface (guide part outer surface 43) of the portion where the substrate guide part 39 is formed). Thus, the locked part 40 can be arranged further toward inner side of the substrate compared to the conventional one (that is, be arranged to reduce in size). Accordingly, the electronic component module 2 can be reduced in size by the amount of being arranged to the inside of the substrate as described above.

According to the electric connection box 1 which is one embodiment of the invention, the configuration includes the electronic component module 2 reduced in size. Thus, the frame (not illustrated) which houses and locks the electronic component module 2 can be reduced in size, and as a result, the electric connection box 1 can be also reduced in size.

The invention can be modified in various forms without departing from the gist of the invention.

### [Description of Reference Numerals and Signs]

- 1:: electric connection box
- 2:: electronic component module
- 3:: substrate
- 4:: connector block (block-shaped member)
- 5:: housing
- 6:: substrate body
- 7:: relay
- 8:: resistance
- 9:: pin terminal
- 10:: substrate front portion
- 11, 13, 15:: end portion
- 12:: substrate side part
- 14:: substrate rear portion
- 16:: block body
- 17:: connector connection part
- 18:: block upper part
- 19:: block lower part
- 20:: block side part
- 21:: fitting part
- 22:: frame part
- 23:: block rear portion
- 24:: locking convex part
- 25:: flange part
- 26:: fine rib
- 27:: substrate fixing part
- 28:: screw
- 29:: opening part
- 30:: internal housing space
- 31:: housing upper wall
- 32:: housing lower wall
- 33:: housing side wall
- 34:: housing bottom wall
- 35:: locking recess part
- 36:: rib
- 37:: looseness suppression rib
- 38:: taper
- 39:: substrate guide part
- 40:: locked part
- 41:: inner surface
- 42:: outer surface
- 43:: guide part outer surface
- 44:: front guide part
- 45:: rear guide part
- 46:: intermediate guide part
- 47, 48:: guided part
- 49, 52:: base part
- 50, 53:: tip part
- 51, 54:: stopper part

## Claims

1. An electronic component module comprising:
a housing; and
a substrate which is configured to be housed in the housing,
wherein the substrate has a substrate side part which extends straight in a housing direction to the housing and which is configured to be guided to the housing when the substrate is housed,
wherein the housing has a substrate guide part which is configured to guide the substrate side part when the substrate is housed, a housing side wall on which the substrate guide part is formed, and a locked part which is formed to be continuous to an outer surface of the housing side wall and which is locked to an attachment destination,
wherein the substrate guide part has a shape in which an end portion of the substrate side part is configured to be positioned outside the outer surface of the housing side wall when the substrate is housed, and
wherein the locked part is positioned in a range from the outer surface of the housing side wall to an outer surface of the substrate guide part.

2. The electronic component module according to claim 1,
wherein the housing has a guided part which is continuous to the outer surface of the housing side wall and which is configured to be guided by a guide part of the attachment destination, and
wherein a base part of the guided part and the substrate guide part are integrally formed.

3. The electronic component module according to claim 1 or 2,
wherein the electronic component module further comprises a block-shaped member which is assembled to the substrate and which is fitted to an opening part of the housing, and
wherein the block-shaped member has a flange part which is positioned to be flush with the substrate side part and which is configured to be guided together with the substrate side part by the substrate guide part.

4. An electric connection box comprising:
the electronic component module according to any one of claims 1, 2 and 3; and
a frame which houses and locks the electronic component module in the frame.

5. A wire harness comprising the electric connection box according to claim 4 in a terminal thereof,
wherein the wire harness is configured to be arranged in a vehicle.
